(19) Europäisches Patentamt

European Patent Office

Office européen des brevets

(11) Publication number: **0 250 990 B1**

## EUROPEAN PATENT SPECIFICATION

(45) Date of publication of patent specification: **16.10.91**

(51) Int. Cl.⁵: **H01L 21/68, B65H 1/00, C23C 16/44**

(21) Application number: **87108515.5**

(22) Date of filing: **12.06.87**

(54) **Wafer transfer apparatus.**

(30) Priority: **26.06.86 JP 150323/86**

(43) Date of publication of application:
**07.01.88 Bulletin 88/01**

(45) Publication of the grant of the patent:
**16.10.91 Bulletin 91/42**

(84) Designated Contracting States:
**DE FR GB**

(56) References cited:
**EP-A- 0 047 132          EP-A- 0 134 621
CA-A- 1 049 662          DE-A- 3 508 516
FR-A- 2 548 449          GB-A- 2 138 775
GB-A- 2 156 582**

(73) Proprietor: **FUJITSU LIMITED
1015, Kamikodanaka Nakahara-ku
Kawasaki-shi Kanagawa 211(JP)**

(72) Inventor: **Kawabata, Taturo Fujitsu Limited
Patent Department
Kosugi Fujitsu Building 1812-10
Shimonumabe
Nakahara-ku Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT(GB)**

EP 0 250 990 B1

## Description

The present invention relates to a wafer transfer apparatus, more particularly, it relates to an apparatus for transferring a plurality of wafers from one wafer carrier to another, for instance in a fabricating process for fabricating semiconductor devices on the wafers.

Generally, semiconductor devices are fabricated on a wafer, and wafer carriers, which will be simply called "carriers" hereinafter, are used for carrying or stocking the wafers in a fabricating process of the semiconductor devices. Since the usage of the carriers depends on the respective processes involved in fabricating the semiconductor devices, it is necessary to transfer the wafers from one carrier, having been used in a former process, to another carrier for a next process. Therefore, it is important that an apparatus for transferring the wafers, which will be called "a wafer transfer apparatus" hereinafter, operates stably because the wafers are very delicate when handled mechanically.

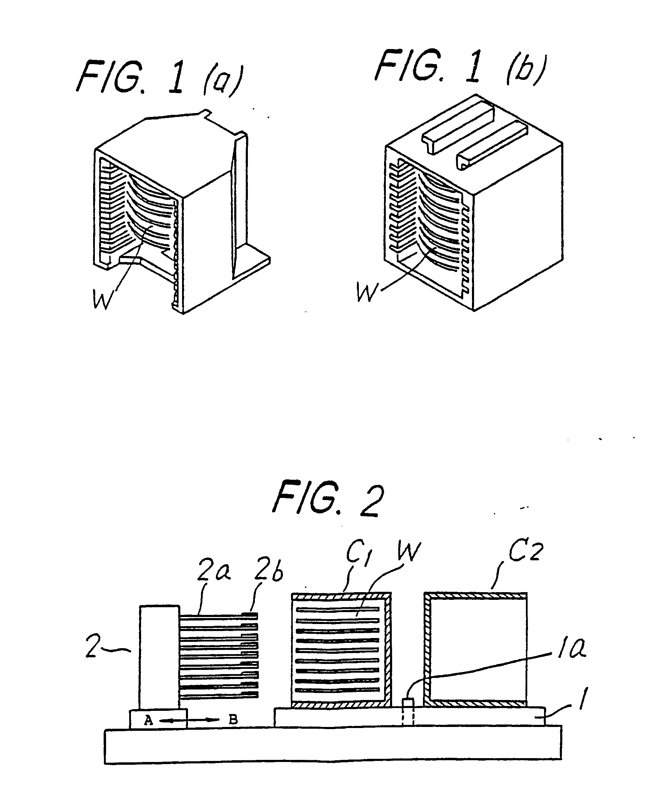

A carrier usually has an external shape of an approximately rectangular prism as shown in Figs. 1(a) and 1(b), and one side (a first side) of the carrier is opened for providing a first opening for putting in or taking out the wafers W from the carrier therethrough. A plurality of the wafers W, twenty-five wafers for example, can be held in the carrier, arranged in parallel leaving a space of 4.76 mm between respective neighboring wafers.

There are two types of carrier: a process type and a box type. Fig. 1(a) shows a typical process type carrier which is to be used in a wafer process such as washing, photo lithography, etching, diffusion and heat treatment. The process type carrier is made of, for example quartz glass or plastics. The process carrier has another opening, which will be called "a second opening" hereinafter, at the side opposite to the first opening. The second opening is for moving the wafers in the process type carrier back and forth from the exterior of the process type carrier. Fig. 1(b) shows a typical box-type carrier for transporting or stocking the wafers. The box-type carrier is made of, for example, plastic and only has the first opening because less opening is better to keep dust away from the wafers W stocked in the box-type carrier, during transportation or stocking.

A wafer transfer apparatus is for transferring the wafers W from one wafer carrier to another. In Fig. 2, a typical wafer transfer apparatus and two box-type carriers C1 and C2 mounted on a turntable 1 of the wafer transfer apparatus are illustrated; a schematic side view for the wafer transfer apparatus and a schematic sectional side view are depicted for the boxtype carriers C1 and C2. Fig. 2 shows that the wafers W stocked in the box type carrier C1 are intended to be transferred to the box type carrier C2, using a wafer transfer unit 2 of the wafer transfer apparatus. In Fig. 2, the turn table 1 of the wafer transfer apparatus is turned on an axis 1a, turning the box type carriers C1 and C2 simultaneously. When the wafers W in the box type carrier C1 are transferred to the box type carrier C2, the transference is carried out in accordance with the following steps of: (1) turning the box type carrier C1 so that the opening (the first opening) of the carrier C1 just faces the wafer transfer unit 2 (Fig. 2 shows this state); (2) inserting arms 2a of the wafer transfer unit 2 into the spaces among the wafers W by shifting the wafer transfer unit 2 in a direction B; (3) chucking a wafer W placed above each arm 2a by using a chuck 2b equipped on each arm 2a; (4) shifting the wafer transfer unit 2 back in a direction A taking out the wafers W from the carrier C1; (5) turning the turn table 1 so that the opening (the first opening) of the carrier C2 just faces the wafer transfer unit 2; (6) inserting the wafers W into the carrier C2 by shifting the wafer transfer unit 2 in the direction B; (7) placing the wafers W in the carrier C2 by releasing the chuck 2b; and (8) shifting the wafer transfer unit 2 back in the direction A.

However, in the above steps, particularly in the above step (2), since the space between the wafers in the carrier C1 or C2 is very narrow, as described before, the arm 2a must be very thin, in other words, the arm 2a becomes mechanically very weak. Accordingly, in the wafer transfer apparatus, the end of each arm 2a is very hard to be positioned correctly between the wafers in the carrier C1; in other words, the insertion of the arms 2a becomes unstable. This is a first problem of the wafer transfer apparatus.

The above first problem may be solved if arms 2a are not used, and this may be achieved by applying an idea of the Japanese Laid-open Patent 50-34481 to Jun Suzuki, which will be called the "Suzuki" hereinafter. According to the "Suzuki", wafers can be transferred from one carrier to another without using arms. Namely, wafers are transferred using weight of the wafers themselves. Each of two carriers applied to the "Suzuki" is a process type having a first opening through which wafers are transferred and a second opening through which a supporter belonging to each carrier is inserted into the carrier. Wherein, the first opening and the second opening of each carrier are located on sides opposite to each other. The transference of the wafers is carried out in accordance with the following steps.

(1) A first carrier, in which wafers to be transferred are stocked, is set so that a side of the first opening of the first carrier is directed upward. The wafers are supported by a first supporter which belongs to the first carrier and inserted into the first carrier through the second opening of the first carrier so that the wafers are on the first supporter.

(2) A second carrier, to which the wafers will be transferred, is put on the first carrier so that the first opening of the second carrier is directed downward and joined to the first opening of the first carrier. Then, a second supporter belonging to the second carrier supports the wafers so as to touch the upper side of the wafers.

(3) The first and the second carriers joined together are turned upside down and the wafers in the first carrier are transferred to the second carrier using their weight by moving the second supporter of the second carrier downward. At that time, the first supporter of the first carrier is also moved down lightly touching the upper side of the wafers.

(4) The first carrier is taken apart from the second carrier. Then, the transference of the wafers are completed.

In the above explanation, the second supporter is necessary for avoiding the wafers rolling down into the second carrier during the transference of the wafers, and the first supporter works so that the wafers can be transferred smoothly for avoiding irregular transferring motion occurring. As seen from the above explanation of the steps, the second openings of the first and the second carriers are necessary to allow the first and the second supporters operate, which means that the "Suzuki" can be applied only when the carriers are the process type, in other words, the box-type carriers cannot be applied in the "Suzuki" because the box-type carrier has only the first opening. This is a second problem.

An embodiment of the present invention can transfer the wafers from one carrier to the other without using arms.

An embodiment of the present invention can transfer the wafers from one carrier to the other, stably without damaging the wafers.

An embodiment of the present invention can apply not only the process type carrier but also the box-type carrier to the wafer transfer apparatus for transferring the wafers.

In an embodiment of the present invention this is achieved by: first, providing a wafer holder for temporarily holding the wafers during the transference of the wafers from one carrier (a first carrier) to another carrier (a second carrier), wherein the wafer holder has an opening (a third opening), directed upward, through which the wafers are transferred; second, turning the first and the second carriers so that a first and a second opening provided respectively to the first and the second carriers for transferring the wafers, are directed downward for facing the third opening respectively; third, providing a wafer supporter for supporting the wafers when the wafers are transferred from the first carrier to the wafer holder and from the wafer holder to the second carrier respectively; forth, providing a wafer sustainer to the first and second carriers respectively for sustaining the wafers in the first and the second carriers when the first and the second carriers are turned so that the first and the second openings are directed downward respectively, which is for avoiding the wafers falling down from the first and the second carriers respectively when the carriers are turned; and fifth, a wafer holder moving means for carrying the wafers holded in the wafer holder from a point at which the third opening faces the first opening directed downward to another point at which the third opening faces the second opening. According to the present invention, the wafers can be transferred by using the weight of the wafers themselves and not using arms, so that the transference of the wafers can be done stably without damaging the wafers. Furthermore, according to the present invention, only one opening is enough to each carrier to transfer the wafers, which means that not only the process type carrier but also the box type carrier can be used to the wafer transfer apparatus of the present invention.

Reference is made, by way of example, to the accompanying drawings, in which:-

Fig. 1(a) is a schematic perspective illustration of a process type carrier, and Fig. 1(b) is a schematic perspective illustration of a box-type carrier;

Fig. 2 is a schematic side view of a previous wafer transfer apparatus;

Fig. 3 is a schematic perspective illustration of a wafer transfer apparatus embodying the present invention;

Fig. 4 is a rotary mechanism for performing the operation of a wafer sustainer and a carrier stage of a wafer transfer apparatus embodying the present invention;

Figs. 5(a) to 5(e) are illustrations for showing the operating steps of a wafer transfer apparatus embodying the present invention.

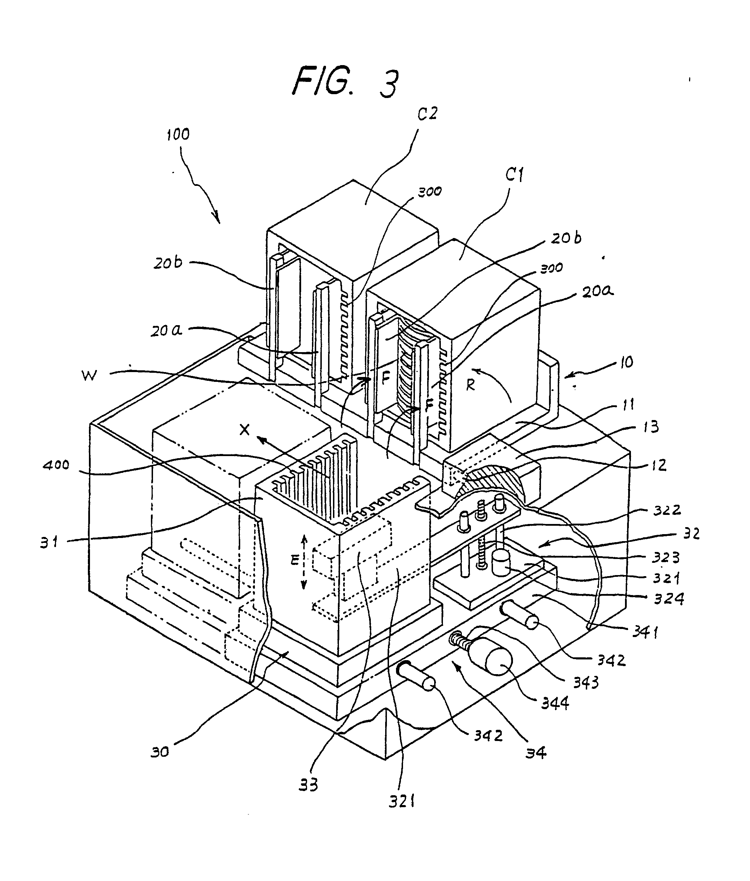

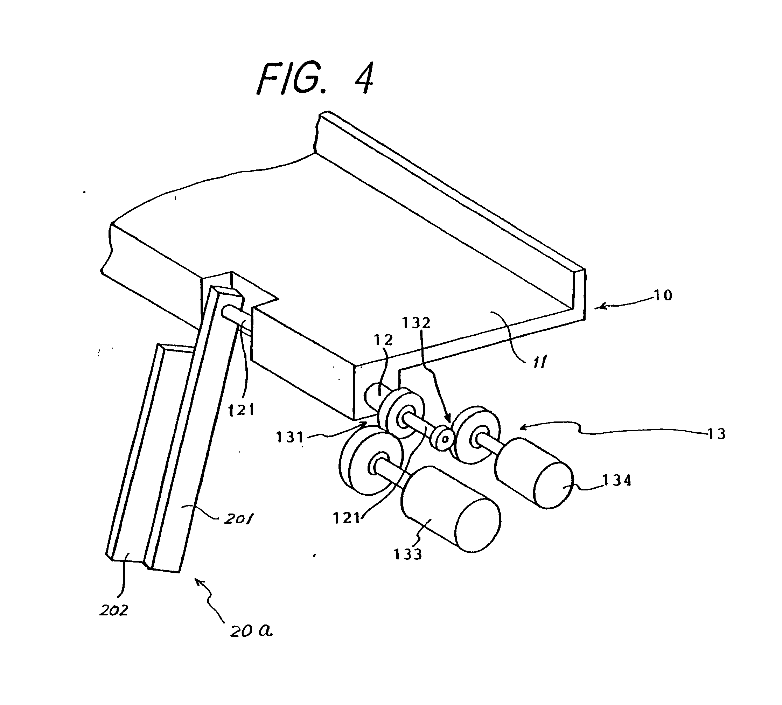

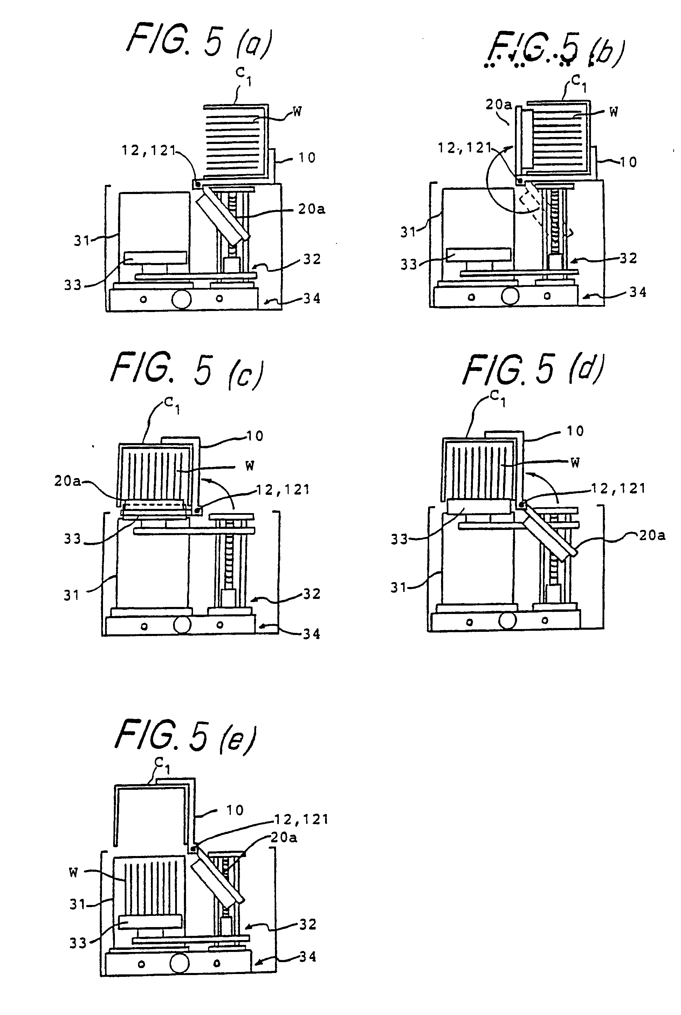

A wafer transfer apparatus embodying the present invention will be explained referring to Figs. 3, 4 and 5(a) to 5(e). Wherein, Fig. 3 shows a schematic perspective illustration of the wafer transfer apparatus 100 embodying the present invention; Fig. 4 shows a rotary mechanism for performing operation of a wafer sustainer and a carrier stage of the wafer transfer apparatus 100; and Figs. 5(a) to 5(e) show the wafer transferring steps of the wafer transfer apparatus 100. Throughout the Figures, the same reference numeral or symbol designates the same part or unit.

According to the present invention there is provided a wafer transfer apparatus for transferring wafers in a first wafer carrier to a second wafer carrier through a first opening and a second opening provided in the first and second wafer carriers respectively, said apparatus comprising:-

(a) a carrier turning means for turning the first and second wafer carriers from an original state to a state in which the first and second openings are directed downwardly,

(b) a wafer holding means for holding the wafers which are being transferred from the first wafer carrier to the second wafer carrier said wafer holding means comprising a third opening which is directed upwardly to face the downwardly directed first opening when wafers in the first wafer carrier are transferred to the wafer holding means and to face the downwardly directed second opening when wafers held in the wafer holding means are transferred to the second wafer carrier, by relatively moving the position of the wafer holding means into correspondence with the positions of the first and second wafer carriers respectively, and

(c) a wafer supporting means for

supporting the wafers which are being transferred from the first wafer carrier to the wafer holding means, when the wafers in the first wafer carrier are being transferred to the wafer holding means,

installing the wafers from the first wafer carrier into the wafer holding means, and

supporting the wafers which are being transferred from the wafer holding means to the second wafer carrier, when the wafers in the wafer holding means are being transferred to the second wafer carrier.

In Fig. 3, wafers W are stocked in a box type carrier C1 and intended to be transferred to another box type carrier C2. The carriers C1 and C2 are mounted on and fixed to a table 11 of a carrier stage 10 of the wafer transfer apparatus 100, and the wafers W are and will be stocked so as to be set horizontally in grooves 300, made of, for example, resin, provided in the carriers C1 and C2 respectively.

A wafer transferring unit 30 is located below the carrier stage 10 and comprises a wafer holder 31, a supporter elevating mechanism 32 having an elevating arm 321 on which a wafer supporter 33, made of, for example, resin, is equipped at the end thereof, and a holder shifting mechanism 34. The holder shifting mechanism 34 comprises a first pedestal 341 which is shifted horizontally in a direction shown by an arrow X when the wafers W are transferred from the wafer carrier C1 to C2. The shift is performed along first guide rods 342 by a driving screw 343 which is driven by a first motor 344. The wafer holder 31 and the supporter elevating mechanism 32 are mounted on and fixed to the first pedestal 341. The supporter elevating mechanism 32 comprises a second pedestal 321, second guide rods 322, a second driving screw 323, a second motor 324, and the elevating arm 321. The elevating arm 321 is driven up and down by the rotation of the second driving screw 323 driven by the second motor 324, so that the wafer supporter 33 is moved up and down as shown by an arrow E in the wafer holder 31. As seen in Fig. 3, two sides of the wafer holder 31 are opened, one of which is directed upward for allowing the transference of the wafers, and the other of which is located at the side of the wafer holder 31 for allowing the arm 321 moving up or down so as to elevate or lower the wafer supporter 33. Usually, the wafer supporter 33 is positioned at the bottom of the wafer holder 31. When the wafers W are transferred to the wafer holder 31, the wafer supporter 33 is elevated to accept the wafers W.

When the wafers W are transferred from one carrier (the carrier C1 in Fig. 3) to another (the carrier C2), the carrier stage 10 is turned on an axis 12 approximately one-forth revolution with the carriers C1 and C2 mounted thereon as shown by an arrow R in Fig. 3, until the opening of the carrier C1 faces the opening of the the wafer holder 31 having a slight space. At each opening of the carriers C1 and C2, a pair of wafer sustainers 20a and 20b are provided. Each wafer sustainer 20a or 20b comprises a second arm 201 and an attaching part 202 as shown in Fig. 4; wherein, the attaching part 202 is made of, for example, resin for lightly sustaining the wafers W. In Fig. 3, the wafers W stocked in the carrier C1 are sustained by the wafer sustainers 20a and 20b. This is for avoiding the wafers W falling down from the carrier C1 when the carrier stage 10 is turned so that the opening of the carrier C1 is directed downward. When the carriers C1 and C2 are mounted on the carrier stage 10, the wafer sustainers 20a and 20b are positioned at the down side of the wafer stage 10 as shown in Fig. 5(a). After the carriers C1 and C2 are mounted on the table 11 of the carrier stage 10, the wafer sustainers 20a and 20b are turned on an axis 121 as shown by arrows F in Fig. 3, which will be detailed later referring Fig. 4, until the wafers W in the wafer carrier C1 are sustained by the wafer sustainers 20a and 20b as shown in Fig. 5(b). After the openings of the carrier C1 and the wafer holder 31 are faced each other having a space, the wafers W stocked in the carrier C1 are received by the wafer supporter 33 as shown in Fig. 5(c). Then, the wafer sustainers 20a and 20b are turned on the axis 121 so as to return to their initial position as shown in Fig. 5(a), so that the wafers W are on the wafer supporter 33 as shown in Fig. 5(d). After that, the supporter elevating mechanism 32 moves the wafer supporter 33 down installing the wafers W in grooves 400, which are made of, for example, resin and provided in the wafer holder 31 as indicated in Fig. 3, in the wafer holder 31 as shown in Fig. 5(e). After installation of the wafers W in the wafer holder 31 is completed, the holder shifting mechanism 34 shifts the wafer holder 31 until the opening of the wafer holder 31 is positioned just below the opening of the other carrier C2, which is directed downward. Then the wafer supporter 33 is elevated until the wafers W, which is on the wafer supporter 33, are transferred to the carrier C2. After the wafers W are transferred in the carrier C2, the wafer sustainers 20a and 20b are turned so that the wafer sustainers 20a and 20b sustain the wafers W which have stocked in the carrier C2. Then, the carrier stage 10 is turned back on the axis 12 approximately one-forth revolution so that the carrier stage 10 is at an initial position as shown in Fig. 3. After that, the wafer sustainers 20a and 20b are turned back to the initial position as shown in Fig. 5(a).

In Fig. 3, reference numeral 13 is a rotary mechanism for turning the carrier stage 10 and the wafer sustainers 20a and 20b. Fig. 4 shows the details of the rotary mechanism 13. In Fig. 4, reference numeral 12 is the axis for rotating the wafer stage 10 approximately one-forth revolution as explained before. However, the axis 13 is a double axis having another axis 121 therein so that an outer pipe formed axis 12 is for rotating the wafer stage 10 and an inner axis 121 is for rotating the wafer sustainers 20a and 20b. As shown in Fig. 4, the outer axis 12 is driven by a third motor 133 through a first gear train 131, and the inner axis 121 is driven by a forth motor 134 through a second gear train 132.

In Fig. 3, the first motor 344 is for shifting the holder shifting mechanism 34, the second motor 324 is for driving the supporter elevating mechanism 32, the first, second, third, and forth motors mentioned above can be automatically driven in accordance with, for example, a program previously provided. The wafer carriers are usually mounted on the apparatus by hand. However, the apparatus can be set on the way of a line for a wafer carrier transportation. In this case, the carriers can be automatically mounted on and demounted from the carrier stage of the wafer transfer apparatus.

As explained above, in wafer transfer apparatus embodying the present invention, the transference of the wafers can be performed very smoothly because there is no unstable matter such as using arms as done in the prior art. Furthermore, wafer transfer apparatus embodying the present invention can transfer wafers only using the opening for transferring the wafers. In other words, even though a carrier applied to the wafer transfer apparatus embodying the present invention may be a box type, the wafers can be transferred; that is, there is no necessity to use another opening such as the second opening of the process type carrier.

Wafers stocked in a first wafer carrier (C2) are transferred to a second wafer carrier (C1) by way of a first opening and a second opening provided respectively in the first and the second wafer carriers, and by way of a mobile wafer holder (31).

Initially, the wafer carriers (C1, C2) hold the wafers (W) horizontal, with their openings facing sideways. The carriers (C1, C2) are then turned so that the first and second openings are directed downward with the wafers vertical. The wafers (W) in the first wafer carrier (C1) are then received and supported by a wafer supporter (33) provided in the wafer holder (31) and installed in the wafer holder (31) by moving down the supporter (33) from the now downward facing first opening through an upward facing third opening of the wafer holder. With the wafers installed the wafer holder (31) is shifted until the third opening confronts the downward facing second opening. The wafers held in the wafer holder (31) are transferred to the second wafer carrier by moving the wafer supporter (33) upwards, then the second wafer carrier (C2) is turned so that the second opening again faces sideways, and wafer transference is completed.

## Claims

1. A wafer transfer apparatus (100) for transferring wafers in a first wafer carrier (C1) to a second wafer carrier (C2) through a first opening and a second opening provided in the first (C1) and second (C2) wafer carriers respectively, said apparatus comprising:-

   (a) a carrier turning means (10) for turning the first (C1) and second (C2) wafer carriers from an original state to a state in which the first and second openings are directed downwardly,

   (b) a wafer holding means (31) for holding the wafers which are being transferred from the first wafer carrier (C1) to the second wafer carrier (C2), said wafer holding means (31) comprising a third opening which is directed upwardly to face the downwardly directed first opening when wafers in the first wafer carrier (C1) are transferred to the wafer holding means (31) and to face the downwardly directed second opening when wafers held in the wafer holding means (31) are transferred to the second wafer carrier (C2), by relatively moving the position of the wafer holding means (31) into correspondence with the positions of the first (C1) and second (C2) wafer carriers respectively, and
(c) a wafer supporting means (33) for
supporting the wafers which are being transferred from the first wafer carrier (C1) to the wafer holding means (31), when the wafers in the first wafer carrier (C1) are being transferred to the wafer holding means (31),
installing the wafers from the first wafer carrier (C1) into the wafer holding means (31), and
supporting the wafers which are being transferred from the wafer holding means (31) to the second wafer carrier (C2), when the wafers in the wafer holding means (31) are being transferred to the second wafer carrier (C2).

2. An apparatus as claimed in claim 1, further comprising first and second wafer sustaining means (20a, 20b),
the first wafer sustaining means (20a, 20b) serving for sustaining the wafers in the first wafer carrier (C1) when the first wafer carrier (C1) is being turned from the original state to a state in which the first opening is directed downwardly, and when the first wafer carrier (C1) is in the state in which the first opening is directed downwardly until the wafer supporting means (33) supports the wafers,
the second wafer sustaining means (20a, 20b) serving for sustaining the wafers supported by the wafer supporting means (33) to transfer the wafers from the wafer holding means (31) to the second wafer carrier (C2), until the second wafer carrier (C2) is turned back to the original state.

3. An apparatus as claimed in claim 2,
wherein
the carrier turning means comprise,
a carrier stage (10) for mounting and fixing the first (C1) and second (C2) wafer carriers, and
carrier stage turning means (12, 133, 131) for turning the carrier stage (10), with the first (C1) and second (C2) wafer carriers thereon;
wherein
the wafer holding means (31) holds wafers vertically therein;
wherein
the wafer supporting means (33) is moved upwardly when the wafers are to be transferred from the first wafer carrier (C1) to the wafer holding means (31), moved downwardly when the wafers are being installed and held in the wafer holder means (31), and moved upwardly when the wafers are transferred from the wafer holder means (31) to the second wafer carrier (C2), the apparatus comprising elevating means (32) for moving the wafer supporting means (33) upwardly and downwardly;
wherein
the apparatus comprises wafer holder moving means (34) for moving the wafer holding means (31), together with the elevating means (32), from a position at which the third opening faces the downwardly directed first opening to a position at which the third opening faces the downwardly directed second opening;
and wherein
the first and second wafer sustaining means (20a, 20b) sustain the wafers, in the first (C1) and second (C2) wafer carriers respectively, from the exterior of the first and second openings respectively,
the sustaining performed by the first wafer sustaining means (20a, 20b) being released when the wafers being transferred from the first wafer carrier (C1) to the wafer holding means (31) are supported by the wafer supporting means (33), and the sustaining performed by the second wafer sustaining means (20a, 20b) being released when the second wafer carrier is turned to the original state.

4. An apparatus as claimed in claim 3, wherein the wafer supporting means (33) is made of resin.

5. An apparatus as claimed in claim 3, wherein each of the first and second wafer sustaining means (20a, 20b) comprises a part made of resin for directly sustaining the wafers, in the first (C1) and second (C2) wafer carriers respectively.

**Revendications**

1. Appareil de transfert de galette (100) destiné à transférer des galettes dans un premier support de galette (C1) vers un deuxième support de galette (C2) au travers d'une première ouverture et d'une deuxième ouverture prévues respectivement dans les premier (C1) et deuxième (C2) supports de galette, le dit appareil comportant :
a) des moyens de rotation de support (10) destinés à tourner les premier (C1) et deuxième (C2) supports de galette d'un état d'origine vers un état dans lequel les première et deuxième ouvertures sont dirigées vers le bas,
b) des moyens de maintien de galette (31) destinés à maintenir les galettes qui sont transférées du premier support de galette (C1) vers le deuxième support de galette (C2), les dits moyens de maintien de galette (31) comportant une troisième ouverture qui est dirigée vers le haut afin de faire face à la première ouverture dirigée vers le bas lorsque des galettes dans le premier support de galette (C1) sont transférées vers les moyens de maintien de galette (31) et afin de faire face à la deuxième ouverture dirigée vers le bas lorsque des galettes maintenues dans les moyens de maintien de galette (31) sont transférées vers le deuxième support de galette (C2), en déplaçant de manière relative la position des moyens de maintien de galette (31) en correspondance respectivement avec les positions des premier (C1) et deuxième (C2) supports de galette, et

(c) des moyens de support de galette (33) destinés à

supporter les galettes qui sont transférées du premier support de galette (C1) vers les moyens de maintien de galette (31), lorsque les galettes dans le premier support de galette (C1) sont transférées vers les moyens de maintien de galette (31),

installer les galettes du premier support de galette (C1) dans les moyens de maintien de galette (31), et

supporter les galettes qui sont transférées des moyens de maintien de galette (31) vers le deuxième support de galette (C2), lorsque les galettes dans les moyens de maintien de galette (31) sont transférées vers le deuxième support de galette (C2).

2. Appareil selon la revendication 1, comportant en outre des premiers et deuxièmes moyens de soutien de galette (20a, 20b),

les premiers moyens de soutien de galette (20a, 20b) servant à soutenir les galettes dans le premier support de galette (C1) lorsque le premier support de galette (C1) est tourné de l'état d'origine vers un état dans lequel la première ouverture est dirigée vers le bas, et lorsque le premier support de galette (C1) est dans l'état dans lequel la première ouverture est dirigée vers le bas jusqu'à ce que les moyens de support de galette (33) supportent les galettes,

les deuxièmes moyens de soutien de galette (20a, 20b) servant à soutenir les galettes supportées par les moyens de support de galette (33) afin de transférer les galettes des moyens de maintien de galette (31) vers le deuxième support de galette (C2), jusqu'à ce que le deuxième support de galette (C2) soit revenu vers l'état d'origine.

3. Appareil selon la revendication 2, dans lequel les moyens de rotation de support comportent,

un étage de support (10) destiné à monter et fixer les premier (C1) et deuxième (C2) supports de galette, et

des moyens de rotation d'étage de support (12, 133, 131) destinés à faire tourner l'étage de support (10), avec les premier (C1) et deuxième (C2) supports de galette dessus;
dans lequel

les moyens de maintien de galette (31) supportent les galettes verticalement;
dans lequel

les moyens de support de galette (33) sont déplacés verticalement lorsque les galettes doivent être transférées du premier support de galette (C1) vers les moyens de maintien de galette (31), déplacées vers le bas lorsque les galettes sont installées et maintenues dans les moyens de maintien de galette (31), et déplacées vers le haut lorsque les galettes sont transférées des moyens de maintien de galette (31) vers le deuxième support de galette (C2), l'appareil comportant des moyens d'élévation (32) destinés à déplacer le moyens de support de galette (33) vers le haut et vers le bas;
dans lequel

l'appareil comporte des moyens de déplacement de porte-galette (34) destinés à déplacer les moyens de maintien de galette (31), avec les moyens d'élévation (32), d'une position dans laquelle la troisième ouverture fait face à la première ouverture dirigée vers le bas vers une position dans laquelle la troisième ouverture fait face à la deuxième ouverture dirigée vers le bas;
et dans lequel

les premiers et deuxièmes moyens de soutien de galette (20a, 20b) soutiennent les galettes, respectivement dans les premier (C1) et deuxième (C2) supports de galette, respectivement depuis l'extérieur des première et deuxième ouvertures,

le soutien réalisé par les premiers moyens de soutien de galette (20a, 20b) étant relâché lorsque les galettes qui sont transférées du premier support de galette (C1) vers les moyens de maintien de galette (31) sont supportées par les moyens de support de galette (33), et le soutien réalisé par les deuxièmes moyens de soutien de galette (20a, 20b) étant relâché lorsque le deuxième support de galette est tourné vers l'état d'origine.

**4.** Appareil selon la revendication 3, dans lequel les moyens de support de galette (33) sont en résine.

**5.** Appareil selon la revendication 3, dans lequel chacun des premiers et deuxièmes moyens de soutien de galette (20a, 20b) comporte une partie réalisée en résine afin soutenir directement les galettes, respectivement dans les premier (C1) et deuxième (C2) supports de galette.

**Patentansprüche**

**1.** Wafertransfervorrichtung (100) zum Transferieren von Wafern von einem ersten Waferträger (C1) zu einem zweiten Waferträger (C2), durch eine erste Öffnung und eine zweite Öffnung, die in dem ersten (C1) bzw. zweiten (C2) Waferträger vorgesehen sind, welche Vorrichtung umfaßt:-

(a) eine Trägerwendeeinrichtung (10), zum Wenden der ersten (C1) und zweiten (C2) Waferträger von einem ursprünglichen Zustand in einen Zustand, in dem die ersten und zweiten Öffnungen nach unten gerichtet sind,

(b) eine Waferhalteeinrichtung (31), um die Wafer zu halten, die von dem ersten Waferträger (C1) zu dem zweiten Waferträger (C2) transferiert werden, welche Waferhalteeinrichtung (31) eine dritte Öffnung aufweist, die nach oben gerichtet ist, um der nach unten gerichteten ersten Öffnung entgegenzusehen, wenn Wafer in dem ersten Waferträger (C1) zu der Waferhalteeinrichtung (31) transferiert werden, und um der nach unten gerichteten zweiten Öffnung entgegenzusehen, wenn Wafer, die in der Waferhalteeinrichtung (31) gehalten werden, zu dem zweiten Waferträger (C2) transferiert werden, durch relatives Bewegen der Position der Waferhalteeinrichtung (31) in Übereinstimmung mit den Positionen des ersten (C1) bzw. zweiten (C2) Waferträgers, und

(c) eine Wafertrageinrichtung (33), um die Wafer zu tragen, die von dem ersten Waferträger (c1) zu der Waferhalteeinrichtung (31) transferiert werden, wenn die Wafer in dem ersten Waferträger (C1) zu der Waferhalteeinrichtung (31) transferiert werden,

Installieren der Wafer von dem ersten Waferträger (C1) in die Waferhalteeinrichtung (31), und

Tragen der Wafer, die von der Waferhalteeinrichtung (31) zu dem zweiten Waferträger (C2) transferiert werden, wenn die Wafer in der Waferhalteeinrichtung (31) zu dem zweiten Waferträger (C2) transferiert werden.

**2.** Vorrichtung nach Anspruch 1, ferner mit ersten und zweiten Stützeinrichtungen (20a, 20b),

wobei die erste Waferstützeinrichtung (20a, 20b) dazu dient, die Wafer in dem ersten Waferträger (C1) zu stützen, wenn der erste Waferträger von dem ursprünglichen Zustand zu einem Zustand gewendet wird, in dem die erste Öffnung nach unten gerichtet ist, wenn der erste Waferträger (C1) in dem Zustand ist, in dem die ersten Öffnung nach unten gerichtet ist, bis die Wafertrageinrichtung (33) den Wafer trägt,

wobei die zweite Waferstützeinrichtung (20a, 20b) dazu dient, die Wafer zu stützen, die von der Wafertrageinrichtung (33) getragen werden, um die Wafer von der Waferhalteeinrichtung (31) dem zweiten Waferträger (C2) zu transferieren, bis der zweite Waferträger (C2) in den ursprünglichen Zustand zurückgewendet ist.

**3.** Vorrichtung nach Anspruch 2, bei der

die Trägerwendeeinrichtung umfaßt,

eine Trägerbühne (10), zum Montieren und Befestigen der ersten (C1) und zweiten (C2) Waferträger, und

eine Trägerbühnenwendeeinrichtung (12, 133, 131), um die Trägerbühne (10), mit den ersten (C1) und zweiten (C2) Waferträgern darauf, zu wenden;

bei der

die Waferhalteeinrichtung (31) die Wafer vertikal darin hält;

bei der

die Wafertrageinrichtung (33) nach oben bewegt wird, wenn die Wafer von dem ersten Waferträger (C1) zu der Waferhalteeinrichtung (31) transferiert werden sollen, nach unten bewegt wird, wenn die Wafer installiert werden und in der Waferhalteeinrichtung (31) gehalten werden, und nach oben bewegt wird, wenn die Wafer von der Waferhalteeinrichtung (31) zu dem zweiten Waferträger (C2) transferiert werden, wobei die Vorrichtung Hebeeinrichtungen (32) umfaßt, um die Wafertrageinrichtung (33) aufwärts und abwärts zu bewegen;

bei der

die Vorrichtung eine Waferhalterbewegungseinrichtung (34) umfaßt, um die Waferhalteeinrichtung (31), zusammen mit der Hebeeinrichtung (32) von einer Position, in der die dritte Öffnung der nach unten gerichteten ersten Öffnung entgegensieht, in eine Position, in der die dritte Öffnung der nach unten gerichteten zweiten Öffnung entgegensieht, zu bewegen;

und bei der
die ersten und zweiten Waferstützeinrichtungen (20a, 20b) die Wafer in dem ersten (C1) bzw. zweiten (C2) Waferträger von der Außenseite der ersten bzw. der zweiten Öffnung stützen,

wobei die Stützung durch die erste Waferstützeinrichtung (20a, 20b) freigegeben wird, wenn die Wafer, die von dem ersten Waferträger (C1) der Wafertrageinrichtung (31) transferiert werden, von der Waferhalteeinrichtung (33) getragen werden, und die Stützung durch die zweite Waferstützeinrichtung (20a, 20b) durchgeführt wird, wenn der zweite Waferträger in den ursprünglichen Zustand gewendet wird.

4. Vorrichtung nach Anspruch 3, bei der die Wafertrageinrichtung (33) aus Harz besteht.

5. Vorrichtung nach Anspruch 3, bei der jede der ersten und zweiten Stützeinrichtungen (20a, 20b) ein aus Harz hergestelltes Teil umfaßt, um die Wafer in den ersten (C1) bzw. zweiten (C2) Waferträgern direkt zu stützen.

FIG. 1 (a)

FIG. 1 (b)

FIG. 2

# FIG. 3

FIG. 4

EP 0 250 990 B1

## FIG. 5 (a)

## FIG. 5 (b)

## FIG. 5 (c)

## FIG. 5 (d)

## FIG. 5 (e)

13